# EUROPEAN PATENT APPLICATION

(11) **EP 4 676 184 A1**
(43) Date of publication of application: **07.01.2026**
(21) Application number: 24764038.6
(22) Date of filing: 01.03.2024
(51) Int. Cl.: H10B 61/00, H10N 50/10, H10N 50/20

(54) **MEMORY ELEMENT**

(30) Priority: 01.03.2023 JP 2023030767; 15.05.2023 JP 2023080454
(71) Applicant: Topologic Inc., Tokyo 113-8485 (JP)
(72) Inventor: OHMORI, Hiroyuki, Tokyo 113-8485 (JP); HIGO, Tomoya, Tokyo 113-8485 (JP)
(74) Representative: Winter, Brandl - Partnerschaft mbB
(86) International application number: PCT/JP2024/007787
(87) International publication number: WO 2024/181561

(57) **Abstract**

According to one aspect of the present invention, a memory element is provided. The memory element comprises a pinned layer and a storage layer. The pinned layer is composed of a first ferromagnet having a spontaneous magnetization, and is configured such that the magnetization direction of the first ferromagnet is fixed regardless of data that is written to the memory element. The storage layer is configured to include an antiferromagnet and a second ferromagnet having a spontaneous magnetization. The antiferromagnet is configured to exhibit an anomalous Hall effect, wherein the sign of the anomalous Hall coefficient of the antiferromagnet is reversible in accordance with the data written to the memory element. The second ferromagnet is configured such that the magnetization direction thereof is reversible in conjunction with the sign of the anomalous Hall coefficient of the antiferromagnet in accordance with the data written to the memory element.

## Description

### Technical Field

The present invention relates to memory elements.

### Background Art

PTL 1 discloses technology related to a magnetoresistive element including a magnesium oxide passivation layer, and to a high-speed, ultra-low-power, non-volatile memory using the same. The memory includes a tunnel magnetoresistance (TMR) film, which is composed of a ferromagnetic storage layer, an insulating layer, and a ferromagnetic pinned layer, and an MgO passivation layer on the sidewalls of a protective layer and an orientation control layer. This suppresses element diffusion from each layer of a tunnel magnetoresistance (TMR) element during heat treatment at 350°C or higher, thereby implementing a magnetic memory cell and a magnetic random access memory (MRAM) having stable high-output read characteristics and low-current write characteristics. Furthermore, when CoFeB is used for the ferromagnetic layer and MgO is used for the insulating layer, the MgO passivation layer has a (001) orientation.

### Citation List

### Patent Literature

[PTL 1] International Publication No. 2010/067520

### Summary of Invention

### Technical Problem

However, there is still room for improvement in such memory elements utilizing the tunnel magnetoresistance effect.

### Means for Solving Problems

According to one aspect of the present invention, a memory element is provided. The memory element includes a pinned layer and a storage layer. The pinned layer is composed of a first ferromagnetic material having spontaneous magnetization, and a magnetization direction of the first ferromagnetic material is configured to remain fixed regardless of data written to the memory element. The storage layer is configured to include an antiferromagnetic material and a second ferromagnetic material having spontaneous magnetization. The antiferromagnetic material exhibits an anomalous Hall effect, and a sign of an anomalous Hall coefficient of the antiferromagnetic material is configured to be reversible depending on the data written to the memory element. A magnetization direction of the second ferromagnetic material is configured to be reversible in conjunction with the sign of the anomalous Hall coefficient of the antiferromagnetic material, depending on the data written to the memory element.

According to the configuration as such, a novel memory device can be provided.

### BRIEF DESCRIPTION OF DRAWINGS

[FIG. 1] FIG. 1 is a cross-sectional view illustrating an example of the structure of a memory element 10 according to the present embodiment.
[FIG. 2] FIG. 2 is a front view illustrating an example of the structure of a memory element 11 according to a first modification of the present embodiment.
[FIG. 3] FIG. 3 is a diagram illustrating an example of the structure of a memory element 12 according to a second modification of the present embodiment.
[FIG. 4] FIG. 4 is a front view illustrating an example of the structure of a memory element 13 according to a third modification of the present embodiment.
[FIG. 5] FIG. 5 is a front view illustrating an example of the structure of a memory element 14 according to a fourth modification of the present embodiment.
[FIG. 6] FIG. 6 is a front view illustrating an example of the structure of a memory element 15 according to a fifth modification of the present embodiment.
[FIG. 7] FIG. 7 is a diagram illustrating a configuration example of a memory element 20 including another example of a storage layer M.

### DETAILED DESCRIPTION

Hereinafter, a preferred embodiment of the present disclosure will be described in detail with reference to the accompanying drawings. In this specification and the drawings, components having substantially the same functional configuration are denoted by the same reference numerals, and duplicate descriptions thereof are omitted.

By the way, a program for implementing software described in the present embodiment may be provided on a non-transitory computer-readable recording medium, or it may be made available for download from an external server. Alternatively, it may be provided in a manner that allows the program to be run on an external computer, thereby implementing its functions on a client terminal (i.e., cloud computing).

In the present embodiment, the term "unit" may also include, for example, a combination of hardware resources implemented by a circuit in a broad sense, as well as the information processing performed by software that may be specifically implemented by such hardware resources. Additionally, various types of information are handled in the present embodiment, and such information may be represented by physical values such as signal values indicating voltage or current, by high and low signal levels in a binary bit set consisting of 0s and 1s, or by quantum superposition (i.e., qubits), and communication and computation may be executed by a circuit in a broad sense.

Furthermore, the term "circuit" in a broad sense refers to a circuit that is implemented by appropriately combining at least a circuit, circuitry, processor, and memory. That is, it includes application-specific integrated circuits (ASICs), programmable logic devices (such as simple programmable logic devices (SPLDs), complex programmable logic devices (CPLDs) and field-programmable gate arrays (FPGAs)), and similar devices.

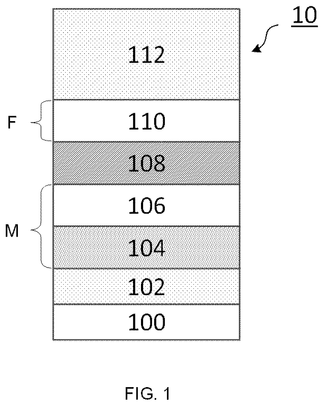

FIG. 1 is a cross-sectional view illustrating an example of the structure of a memory element 10 according to the present embodiment. The memory element 10 illustrated in FIG. 1 includes a substrate 100, an electrode 102, an antiferromagnetic layer 104, a ferromagnetic layer 106, a barrier layer 108, a ferromagnetic layer 110, and an upper layer 112. The memory element 10 according to the present embodiment is a so-called MTJ (Magnetic Tunnel Junction) element, which reads data as "1" or "0" based on the difference in tunnel magnetoresistance between the parallel and antiparallel spin states, utilizing the tunnel magnetoresistance effect. A memory including the memory element 10 can be used, for example, as an MTJ element in MRAM (Magnetoresistive Random Access Memory), the magnetic head of an HDD (Hard Disk Drive), or in racetrack memory. The memory element 10 is expected to be used, for example, in STT (Spin Transfer Torque)-MRAM or SOT (Spin Orbit Torque)-MRAM, but may also be used in conventional vertical MRAM.

The substrate 100 is a substrate made of any material used for memory applications, such as Si.

The electrode 102 is a layer made of an electrode material used for memory applications, such as W. The electrode 102 may be deposited on the substrate 100.

The antiferromagnetic layer 104 is a layer composed of an antiferromagnetic material. The antiferromagnetic material in the present embodiment is, for example, an antiferromagnetic material that exhibits the anomalous Hall effect. The antiferromagnetic material as such is, for example, an antiferromagnetic material in which the anomalous Hall effect is observed in the absence of a magnetic field. The antiferromagnetic material as such is, for example, an antiferromagnetic material in which the anomalous Hall effect is observed at room temperature or higher. The antiferromagnetic material as such is, for example, an antiferromagnetic material capable of taking binary states through spin rotation. The antiferromagnetic material as such is, for example, a non-collinear antiferromagnet. The antiferromagnetic material as such can be composed of one or more materials selected from the group consisting of, for example, Mn₃Sn, Mn₃Pt, Mn₃Ge, Mn₃Ga, and Mn₃Ir. Specifically, the non-collinear antiferromagnet is, for example, an Mn₃X-based alloy such as Mn₃Sn, Mn₃Ge, or Mn₃Ga. These alloys can easily rotate spins, for example, through polarization by a magnetic octupole. As a result, the sign of the anomalous Hall coefficient of the antiferromagnetic material is configured to be reversible depending on data written to the memory element 10. With respect to the composition ratio of the Mn₃X-based alloy, the content of Mn relative to the content of Sn, Ge, or Ga (including those containing two or more of these elements) is preferably 2.5 times or more and 5 times or less. Additionally, the antiferromagnetic material as such may also be, for example, a co-linear antiferromagnet. The co-linear antiferromagnet may be, for example, RuO₂ or Mn₅Si₃. Additionally, the antiferromagnet as such may also be an alloy with a cubic crystal structure, such as Mn₃Pt, Mn₃Ir, Mn₃Rh, or MnPt. The antiferromagnetic layer 104 may be deposited on the electrode 102.

The ferromagnetic layer 106 may be composed of a ferromagnetic material used in ferromagnetic MTJ elements, such as Co, CoFeB, or CoFe, for example. In other words, the ferromagnetic material may include a magnetic element having a magnetic moment. Examples of such magnetic elements include Fe, Co, Ni, Nd, and Gd,. The ferromagnetic layer 106 is a layer that functions as a free layer in the MTJ element. The material composing the ferromagnetic layer 106 is not particularly limited, as long as it is a material that functions as a free layer. The ferromagnetic layer 106 may be a single layer or a multilayer structure. Additionally, since the ferromagnetic layer 106 functions as a free layer, it may include not only the aforementioned ferromagnetic materials but also other magnetic or nonmagnetic materials. The ferromagnetic layer 106 may be deposited on the antiferromagnetic layer 104. In the memory element 10, the antiferromagnetic layer 104 and the ferromagnetic layer 102, which serves as a second ferromagnetic layer, constitute a storage layer M. The ferromagnetic material included in the ferromagnetic layer 102, which serves as the second ferromagnetic layer, corresponds to a second ferromagnetic material. In other words, the storage layer M is configured to include the antiferromagnetic material and the second ferromagnetic material having spontaneous magnetization. For example, the storage layer M includes the antiferromagnetic layer 104, which is composed of the antiferromagnetic material, and the ferromagnetic layer 102, which serves as the second ferromagnetic layer composed of the second ferromagnetic material. According to the configuration as such, operations on the storage layer during data writing can be simplified.

An antiferromagnetic material (e.g., a canted antiferromagnetic material) that exhibits the anomalous Hall effect and has spontaneous magnetization can have the direction of its spontaneous magnetization reversed through, for example, application of an external magnetic field or the like. A change in the direction of spontaneous magnetization indicates a change in the magnetic structure of the antiferromagnetic material. Such a change in the magnetic structure causes a sign reversal of the anomalous Hall coefficient. The sign reversal of the anomalous Hall coefficient indicates a reversal in the direction of the effective magnetic field within the antiferromagnetic material. The reversal of the effective magnetic field within such an antiferromagnetic material can induce the reversal of the spontaneous magnetization of the second ferromagnetic material (ferromagnetic layer 106 in the present embodiment) via magnetic coupling between the antiferromagnetic material (antiferromagnetic layer 104 in the present embodiment) and the second ferromagnetic material. The direction of the external magnetic field applied to the antiferromagnetic layer 104 varies depending on the data written to the memory element 10. As a result, the magnetization direction of the ferromagnetic material is configured to be reversible in conjunction with the sign of the anomalous Hall coefficient of the antiferromagnetic material, depending on the data written to the memory element 10.

The antiferromagnetic layer 104 may be configured to have an interface with the ferromagnetic layer 106. According to the configuration as such, the magnetic coupling between the antiferromagnetic layer 104 and the ferromagnetic layer 106 forming the storage layer M can be enhanced, thereby enhancing the conjunction of the reversal of the anomalous Hall coefficient of the antiferromagnetic layer 104 and the reversal of the magnetization direction of the ferromagnetic layer 106. For example, the ferromagnetic layer 106 may be deposited directly on the antiferromagnetic layer 104 without depositing any other members, such as an insulating film, therebetween. Note that at least a portion of the ferromagnetic layer 106 may come into direct contact with the antiferromagnetic layer 104 and diffuse into the antiferromagnetic layer 104. In this case, the storage layer M may include, in the vicinity of the interface, a diffusion layer in which particles including the magnetic element of the second ferromagnetic material have diffused into the antiferromagnetic layer. According to the configuration as such, the magnetic coupling between the antiferromagnetic layer 104 and the ferromagnetic layer 106, which form the storage layer M, can be further enhanced. The thickness of the antiferromagnetic layer 104 may be greater than the thickness of the ferromagnetic layer 106. This facilitates the application of a magnetic field to the antiferromagnetic layer 104, while enhancing coupling to the spins in the ferromagnetic layer 106. Note that "thickness" refers to the length in the deposition direction in which the layers are deposited. Additionally, "thickness" refers to the average value of the in-plane thickness. The thickness of a layer is also referred to as the film thickness.

The barrier layer 108, which is an example of a first insulating layer, is a nonmagnetic insulating layer provided to enable TMR to occur. The barrier layer 108 is not particularly limited as long as it functions as an insulating layer, such as MgO, AlOₓ, or TiOₓ. The barrier layer 108 is deposited on the ferromagnetic layer 106.

The ferromagnetic layer 110 may be a ferromagnetic material used in ferromagnetic MTJ elements, such as CoFeB or CoFe. The ferromagnetic layer 110 is a layer that functions as a pinned layer in the MTJ element. The material composing the ferromagnetic layer 110 is not particularly limited, as long as it is a material that functions as a pinned layer. The ferromagnetic layer 110 may be a single layer or a multilayer structure. Additionally, since the ferromagnetic layer 110 functions as a pinned layer, it may include not only the aforementioned ferromagnetic materials but also other magnetic or nonmagnetic materials, such as synthetic antiferromagnet (SAF). The ferromagnetic layer 110, which is an example of a first ferromagnetic layer, corresponds to a pinned layer F in the memory element 10. In other words, the memory element 10 includes the pinned layer F and the storage layer M. The ferromagnetic material composing the ferromagnetic layer 110 is an example of the first ferromagnetic material and has spontaneous magnetization. The magnetization direction of the ferromagnetic material composing the ferromagnetic layer 110 is configured to remain fixed regardless of the data written to the memory element 10. Accordingly, by applying an external magnetic field depending on the data to be written, the direction of spontaneous magnetization of the ferromagnetic layer 106 and the ferromagnetic layer 110 can be changed between parallel and antiparallel, thereby changing the tunnel current flowing through the memory element 10. Such changes in tunnel current, that is, changes in tunnel magnetoresistance, can be associated with 0s and 1s during data writing. According to the above configuration, the memory element 10 can be formed using a smaller amount of an antiferromagnetic material compared to a case in which the entire storage layer is composed of the antiferromagnetic material. As a result, it is possible to reduce variations in the crystallinity of the antiferromagnetic material, while suppressing a decrease in the effective magnetic field of the entire storage layer.

The ferromagnetic layer 110, which serves as the pinned layer F, is deposited on the barrier layer 108. In other words, the barrier layer 108 is disposed between the pinned layer F and the storage layer M, and is thereby configured to form a tunnel junction between the pinned layer F and the storage layer M. For example, the barrier layer 108 may be disposed between the ferromagnetic layer 110 and the ferromagnetic layer 106. The antiferromagnetic layer 104 is configured to be connected to the barrier layer 108 via the ferromagnetic layer 106. According to the configuration as such, the antiferromagnetic layer 104 with crystallinity suitable for the structure of the ferromagnetic layer 106 can be obtained. Preferably, the first ferromagnetic material and the second ferromagnetic material each include at least a Co (cobalt) element as particles having a magnetic moment, and more preferably they are composed of Co or CoFeB.

The upper layer 112 is a layer provided above the ferromagnetic layer 110. The upper layer 112 may be provided with an electrode and/or a layer made of a material based on known technology for enabling the memory element 10 to function more efficiently. The configuration of the upper layer 112 is not particularly limited. The upper layer 112 is deposited on the ferromagnetic layer 110, for example.

Preferably, the spin magnetization direction of the antiferromagnetic layer 104, ferromagnetic layer 106 and/or ferromagnetic layer 110 is perpendicular (i.e., deposition direction), but it may also be the in-plane direction.

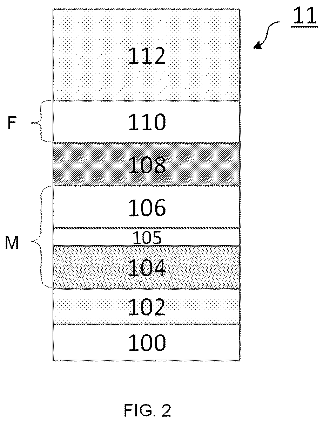

The memory element 10 may further include additional layers between the respective layers. FIG. 2 is a front view illustrating an example of the structure of a memory element 11 according to a first modification of the present embodiment. The memory element 11 illustrated in FIG. 2 may further include, in addition to the layers 100, 102, 104, 106, 108, 110, and 112 of the memory element 10 illustrated in FIG. 1, a first intermediate layer 105. The first intermediate layer 105 is disposed between the antiferromagnetic layer 104 and the ferromagnetic layer 106. The antiferromagnetic layer 104, the first intermediate layer 105, and the ferromagnetic layer 106 constitute the storage layer M of the memory element 11. Therefore, the ferromagnetic layer 106 need not have an interface with the antiferromagnetic layer 104.

The first intermediate layer 105 may, for example, suppress the diffusion of each atom included in the antiferromagnetic layer 104 and the ferromagnetic layer 106 during heat treatment. Additionally, the first intermediate layer 105 may, for example, suppress an increase in surface roughness due to heat treatment of the antiferromagnetic layer 104. The first intermediate layer 105 may also encourage perpendicular magnetization of the upper and lower layers. Therefore, the storage layer M need not include a diffusion layer.

The material composing the first intermediate layer 105 may be, for example, Ta, Mo, Ru, or MgO. The material may also be a multilayer structure of Co/Pt or Ni/Co. Additionally, the material may also be MnSnPt, a Co or CoFe/Ta layer, TbFeCo, Gd, or the like.

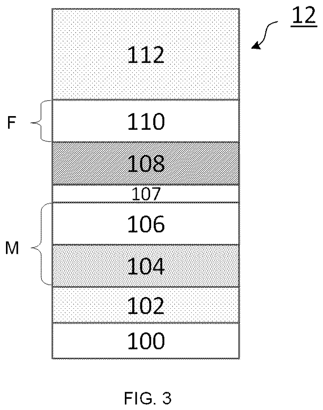

FIG. 3 is a diagram illustrating an example of the structure of a memory element 12 according to a second modification of the present embodiment. The memory element 12 illustrated in FIG. 3 may further include, in addition to the layers 100, 102, 104, 106, 108, 110, and 112 of the memory element 10 illustrated in FIG. 1, a second intermediate layer 107. The second intermediate layer 107 may be disposed between the ferromagnetic layer 106 and the barrier layer 108.

The second intermediate layer 107 may be, for example, a layer for facilitating control of the interface structure or the like. The material composing the second intermediate layer 107 may be Co, Fe, NdCo, Ru, Pd, or Ir, for example. In addition, any known material used as an intermediate layer between a ferromagnetic layer and a barrier layer in a ferromagnetic MTJ element may be applicable. Note that the second intermediate layer 107 may be separate from the storage layer M or may be part of the storage layer M.

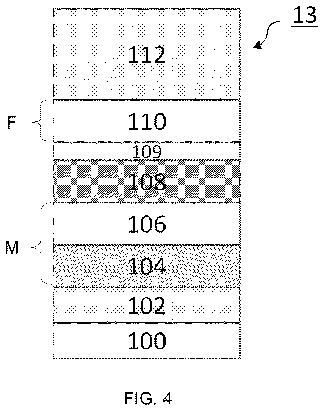

FIG. 4 is a front view illustrating an example of the structure of a memory element 13 according to a third embodiment of the present embodiment. The memory element 13 illustrated in FIG. 4 may further include, in addition to the layers 100, 102, 104, 106, 108, 110, and 112 of the memory element 10 illustrated in FIG. 1, a third intermediate layer 109. The third intermediate layer 109 may be disposed between the barrier layer 108 and the ferromagnetic layer 110 in the memory element 10 illustrated in FIG. 1. The third intermediate layer 109 performs a function that is the same as or similar to that of the second intermediate layer 107. The material composing the third intermediate layer 109 is also the same as or similar to that of the second intermediate layer 107.

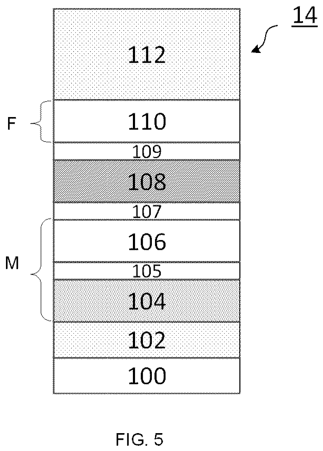

FIG. 5 is a front view illustrating an example of the structure of a memory element 14 according to a fourth modification of the present embodiment. The memory element 14 illustrated in FIG. 5 may further include, in addition to the layers 100, 102, 104, 106, 108, 110, and 112 of the memory element 10 illustrated in FIG. 1, the first intermediate layer 105, the second intermediate layer 107, and the third intermediate layer 109. These intermediate layers 105, 107, and 109 may be selectively included as needed. The specific configurations of these intermediate layers 105, 107, and 109 may be the same as or similar to those described above.

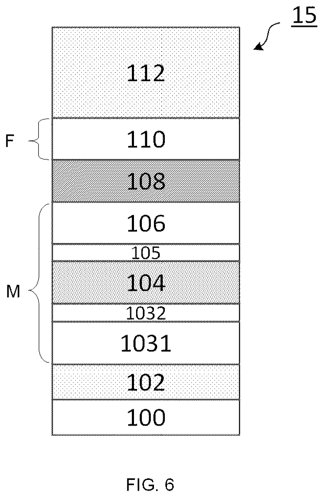

FIG. 6 is a front view illustrating an example of the structure of a memory element 15 according to a fifth modification of the present embodiment. The memory element 15 illustrated in FIG. 6 may further include, in addition to the layers 100, 102, 104, 106, 108, 110, and 112 of the memory element 10 illustrated in FIG. 1, a ferromagnetic layer 1031, a fourth intermediate layer 1032, and the first intermediate layer 105. The ferromagnetic layer 1031 is deposited on the electrode 102. The fourth intermediate layer 1032 is deposited on the electrode 102. The antiferromagnetic layer 104 is deposited on the fourth intermediate layer 1032. The first intermediate layer 105 is the same as or similar to the first intermediate layer 105 included in the memory element 11 illustrated in FIG. 2. Note that the fourth intermediate layer 1032 and the first intermediate layer 105 according to the present modification may or may not be provided.

The ferromagnetic layer 1031 is composed of a material that is the same as or similar to that of the ferromagnetic layer 106 or the ferromagnetic layer 110 described above, for example. By providing the ferromagnetic layer 1031, polarization at the interface between the ferromagnetic layer 1031 and the antiferromagnetic layer 104 becomes possible, making it easier to maintain perpendicular magnetization in the antiferromagnetic layer 104. As a result, the spin rotation efficiency (rotation speed) in the ferromagnetic layer 106 during perpendicular magnetization can be improved. The ferromagnetic layer 1031, the fourth intermediate layer 1032, the antiferromagnetic layer 104, the first intermediate layer 105, and the ferromagnetic layer 106 constitute the storage layer M in the memory element 15. The ferromagnetic layer 1031 corresponds to a third ferromagnetic layer, and a ferromagnetic material composing the ferromagnetic layer 1031 corresponds to a third ferromagnetic material. In other words, the storage layer M may further include the third ferromagnetic layer composed of the third ferromagnetic material. The magnetization direction of the third ferromagnetic material may be configured to be reversible in conjunction with the sign of the anomalous Hall coefficient of the antiferromagnetic material, depending on data written to the memory element 15. The third ferromagnetic layer may be configured to be coupled to the second ferromagnetic layer via an antiferromagnetic layer. According to the configuration as such, the magnetic coupling between the ferromagnetic material and the antiferromagnetic material in the storage layer M can be further enhanced. Note that, also in the fifth modification, the second intermediate layer 107 and the third intermediate layer 109 described above may or may not be provided.

The thickness of each layer of the memory element 15 is arbitrary. For example, the thickness of the ferromagnetic layer 1031 is specifically 0.1, 0.2, 0.3, 0.4, 0.5, 0.6, 0.7, 0.8, 0.9, 1, 1.1, 1.2, 1.3, 1.4, 1.5, 1.6, 1.7, 1.8, 1.9, or 2 nm, for example, and may also be within the range between any two of the exemplified values here. Specifically, the thickness of the ferromagnetic layer 1031 may be from 0.1 to 2 nm, preferably from 0.3 to 1.5 nm, more preferably from 0.4 to 1.3 nm, and yet more preferably from 0.5 to 1.0 nm. Such thickness examples of the ferromagnetic layer 1031 are preferred particularly when a Co-containing material, such as CoFeB, is employed as the ferromagnetic material.

The thickness of the fourth intermediate layer 1032 is specifically 0.1, 0.2, 0.3, 0.4, 0.5, 0.6, 0.7, 0.8, 0.9, or 1 nm, for example, and may also be within the range between any two of the exemplified values here. For example, the thickness of the fourth intermediate layer 1032 may be from 0.1 to 1 nm, preferably from 0.1 to 0.8 nm, more preferably from 0.2 to 0.5 nm. Such thickness examples of the fourth intermediate layer 1032 mentioned above are preferred particularly when a material with low reactivity with adjacent layers, such as MgO or Ta, is employed as the material composing the fourth intermediate layer 1032.

The thickness of the antiferromagnetic layer 104 is specifically 1, 2, 3, 4, 5, 6, 7, 8, 9, 10, 11, 12, 13, 14, 15, 16, 17, 18, 19, or 20 nm, for example, and may also be within the range between any two of the exemplified values here. For example, the thickness of the antiferromagnetic layer may be from 1 to 20 nm, preferably from 2 to 18 nm, more preferably from 3 to 16 nm, yet more preferably from 4 to 14 nm, and further preferably from 5 to 10 nm. Such thicknesses of the antiferromagnetic layer 104 are preferred when a non-collinear antiferromagnetic material is employed as the antiferromagnet, such as an Mn₃X-based material, and more specifically, Mn₃Si.

The thickness of the first intermediate layer 105 is specifically 0.1, 0.2, 0.3, 0.4, 0.5, 0.6, 0.7, 0.8, 0.9, or 1 nm, for example, and may also be within the range between any two of the exemplified values here. For example, the thickness of the first intermediate layer 105 is from 0.1 to 1 nm, preferably from 0.1 to 0.8 nm, and more preferably from 0.2 to 0.5 nm. Such thickness examples of the first intermediate layer 105 mentioned above are preferred particularly when a material with low reactivity with adjacent layers, such as MgO or Ta, is employed as the material composing the first intermediate layer 105.

For example, the thickness of the ferromagnetic layer 106 is specifically 0.1, 0.2, 0.3, 0.4, 0.5, 0.6, 0.7, 0.8, 0.9, 1, 1.1, 1.2, 1.3, 1.4, 1.5, 1.6, 1.7, 1.8, 1.9, or 2 nm, for example, and may also be within the range between any two of the exemplified values here. Specifically, the thickness of the ferromagnetic layer 106 may be from 0.1 to 2 nm, preferably from 0.3 to 1.5 nm, more preferably from 0.4 to 1.3 nm, and yet more preferably from 0.5 to 1.0 nm. Such thickness examples of the ferromagnetic layer 106 are preferred particularly when a Co-containing material, such as CoFeB, is employed as the ferromagnetic material. As described above, the thickness of the antiferromagnetic layer 104 may be greater than the thickness of the ferromagnetic layer 106. This facilitates the application of a magnetic field to the antiferromagnetic layer 104, while enhancing coupling to the spins in the ferromagnetic layer 106.

Next, a method for controlling memory write operations using the memory elements 10 to 15 described in the present embodiment and various modifications thereof will be briefly described. For example, in STT-MRAM or the like, during writing, a current is applied in the deposition direction of the memory element 10, whereby the spins in the antiferromagnetic layer 104 are first reversed. At that time, due to magnetic coupling, the spins in the ferromagnetic layer 106 are also reversed accordingly. This enables the writing of "1" or "0" into memory. In this case, unlike the spins in a conventional ferromagnetic layer, the spin reversal in the antiferromagnetic layer 104 with a high spin reversal speed is prioritized, thereby allowing spin reversal to occur at a faster speed than in the conventional ferromagnetic layer. The same is true for SOT-MRAM, where spin reversal first occurs in the antiferromagnetic layer 104, which in turn can induce spin reversal in the ferromagnetic layer 106 through magnetic coupling. The same also applies to MRAM in which spin reversal is caused by an external magnetic field.

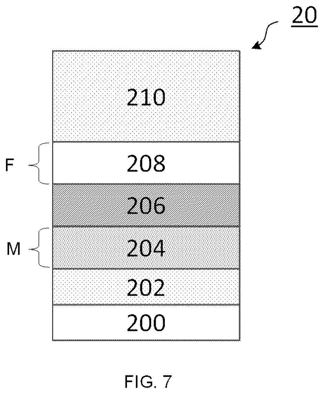

Next, another example of the storage layer M will be described. FIG. 7 is a diagram illustrating a configuration example of a memory element 20 including another example of the storage layer M. The memory element 20 may include a substrate 200, an electrode 202, the storage layer M, a barrier layer 214, the pinned layer F, and an upper layer 216.

The specific configuration of the substrate 200 is the same as or similar to that of the substrate 100 mentioned above.

The electrode 202 is deposited on the substrate 200. The specific configuration of the electrode 202 is the same as or similar to that of the electrode 102.

The storage layer M is deposited on the electrode 202. The storage layer M is configured to change its magnetic state relative to the pinned layer F. The storage layer M in the present embodiment includes a diffusion layer 204. The diffusion layer 204 is configured such that particles having a magnetic moment, which are included in a ferromagnetic material, diffuse into an antiferromagnetic material exhibiting the anomalous Hall effect. According to the configuration as such, it is possible to form a storage layer that is more compact and has a stronger magnetic moment. The antiferromagnetic material as such is, for example, an antiferromagnetic material in which the anomalous Hall effect is observed in the absence of a magnetic field. The antiferromagnetic material as such is, for example, an antiferromagnetic material in which the anomalous Hall effect is observed at room temperature or higher. The antiferromagnetic material as such is, for example, an antiferromagnet capable of taking binary states through spin rotation. The antiferromagnetic material as such is, for example, a non-collinear antiferromagnet. The antiferromagnetic material as such can be composed of one or more materials selected from the group consisting of, for example, Mn₃Sn, Mn₃Pt, Mn₃Ge, Mn₃Ga, and Mn₃Ir. Specifically, the non-collinear antiferromagnet is, for example, an Mn₃X-based alloy such as Mn₃Sn, Mn₃Ge, or Mn₃Ga. These alloys can easily rotate spins, for example, through polarization by a magnetic octupole. As a result, the sign of the anomalous Hall coefficient of the antiferromagnetic material is configured to be reversible depending on data written to the memory element 10. With respect to the composition ratio of the Mn₃X-based alloy, the content of Mn relative to the content of Sn, Ge, or Ga (including those containing two or more of these elements) is preferably 2.5 times or more and 5 times or less. Additionally, the antiferromagnetic material as such may also be, for example, a co-linear antiferromagnet. The co-linear antiferromagnet may be, for example, RuO₂ or Mn₅Si₃. Additionally, the antiferromagnet as such may also be an alloy with a cubic crystal structure, such as Mn₃Pt, Mn₃Ir, Mn₃Rh, or MnPt.

A ferromagnetic material that diffuses into the antiferromagnetic material of the diffusion layer 204 may be composed of a ferromagnetic material used in ferromagnetic MTJ elements, such as Co, CoFeB, or CoFe, for example, like the ferromagnetic layer 106 mentioned above. In other words, the ferromagnetic material may include a magnetic element having a magnetic moment. Examples of such magnetic elements include Fe, Co, Ni, Nd, and Gd. In particular, Co is preferred as such a magnetic element. The diffusion layer 204 is configured, for example, such that magnetic ions Y, such as Fe, Co, Ni, Gd, or Nd, diffuse into the above-mentioned Mn₃X-based alloy. Hereinafter, for convenience of explanation, a material configured such that magnetic ions Y diffuse into an Mn₃X-based alloy is denoted as Mn₃X(Y). In particular, the diffusion layer 204 is preferably composed of one or more materials selected from the group consisting of Mn₃Si(Co), Mn₃Pt(Co), Mn₃Ge(Co), Mn₃(Co), and Mn₃Ir(Co). It is particularly preferable that the diffusion layer 204 be composed of Mn₃Si(Co).

The diffusion layer 204 may be formed, for example, by deposition using molecular beam epitaxy. The diffusion layer 204 may be obtained by sputtering a small amount of a ferromagnetic material onto an antiferromagnetic material and then performing heat treatment to diffuse the element included in the ferromagnetic material into the antiferromagnetic material. In other words, the second ferromagnetic material may include a magnetic element having a magnetic moment, and the storage layer M may be configured such that at least a magnetic element (e.g., a ferromagnetic element such as Co) of the second ferromagnetic material is dispersed in the antiferromagnetic material. Accordingly, the second ferromagnetic material is not limited to one configured to separate the ferromagnetic layer 106 from the antiferromagnetic layer 104, as described in the memory elements 10 to 15. In other words, the second ferromagnetic material may be formed such that its ferromagnetic element (e.g., Co) is dispersed in the antiferromagnetic material (e.g., Mn₃Sn) of the antiferromagnetic layer 104. The storage layer M may be configured such that a Co (cobalt) element, which is an example of a magnetic element of the second ferromagnetic material, is dispersed in a manner that it is doped into the antiferromagnetic layer 104, or in a manner that it substitutes for an Mn element in the antiferromagnetic material. The second ferromagnetic material and the antiferromagnetic material may form an alloy, a solid solution, or a eutectic. The storage layer M may be configured such that the second ferromagnetic material and the antiferromagnetic material form an inseparable, single-phase structure.

The barrier layer 206, which serves as the first insulating layer, is a nonmagnetic insulating layer provided to enable TMR to occur. The barrier layer 108 is not particularly limited as long as it functions as an insulating layer, such as MgO, AlOₓ, or TiOₓ.

The ferromagnetic layer 208 corresponds to the first ferromagnetic layer and functions as the pinned layer F. The ferromagnetic layer 208 is deposited on the barrier layer 206. The specific configuration of the ferromagnetic layer 208 is the same as or similar to that of the ferromagnetic layer 110 described above.

The upper layer 210 is a layer provided above the ferromagnetic layer 208. The upper layer 210 may be provided with an electrode and/or a layer made of a material based on known technology for enabling the memory element 20 to function more efficiently. The configuration of the upper layer 210 is not particularly limited; the upper layer 210 is deposited, for example, on the ferromagnetic layer 208.

The above-described embodiment may be provided in each of the following modes.
(1) A memory element comprising: a pinned layer; and a storage layer, wherein the pinned layer is composed of a first ferromagnetic material having spontaneous magnetization, and a magnetization direction of the first ferromagnetic material is configured to remain fixed regardless of data written to the memory element; and wherein the storage layer is configured to include an antiferromagnetic material and a second ferromagnetic material having spontaneous magnetization, the antiferromagnetic material exhibits an anomalous Hall effect, and a sign of an anomalous Hall coefficient of the antiferromagnetic material is configured to be reversible depending on the data written to the memory element, and a magnetization direction of the second ferromagnetic material is configured to be reversible in conjunction with the sign of the anomalous Hall coefficient of the antiferromagnetic material, depending on the data written to the memory element.
   According to the configuration as such, a memory element can be formed using a smaller amount of an antiferromagnetic material compared to a case in which the entire storage layer is composed of the antiferromagnetic material. As a result, it is possible to reduce variations in the crystallinity of the antiferromagnetic material, while suppressing a decrease in the effective magnetic field of the entire storage layer.
(2) The memory element according to (1), wherein: the storage layer includes an antiferromagnetic layer composed of the antiferromagnetic material and a second ferromagnetic layer composed of the second ferromagnetic material.
   According to the configuration as such, operations on the storage layer during data writing can be simplified.
(3) The memory element according to (2), further comprising: a first insulating layer, wherein the first insulating layer is disposed between the pinned layer and the storage layer, and is thereby configured to form a tunnel junction between the pinned layer and the storage layer, and wherein the antiferromagnetic layer is configured to be connected to the first insulating layer via the second ferromagnetic layer.
   According to the configuration as such, the antiferromagnetic layer with crystallinity suitable for the structure of the second ferromagnetic layer can be obtained.
(4) The memory element according to (2) or (3), wherein: the antiferromagnetic layer is configured to have an interface with the second ferromagnetic layer.
   According to the configuration as such, the magnetic coupling between the antiferromagnetic layer and the second ferromagnetic layer forming the storage layer can be enhanced, thereby enhancing the conjunction of the reversal of the anomalous Hall coefficient of the antiferromagnetic layer and the reversal of the magnetization direction of the second ferromagnetic layer.
(5) The memory element according to (4), wherein: the second ferromagnetic material includes a magnetic element having a magnetic moment; and the storage layer includes, in vicinity of the interface, a diffusion layer in which particles including the magnetic element of the second ferromagnetic material have diffused into the antiferromagnetic layer.
   According to the configuration as such, the magnetic coupling between the antiferromagnetic layer and the second ferromagnetic layer forming the storage layer can be further enhanced.
(6) The memory element according to any one of (2) to (5), wherein: the second ferromagnetic material includes a magnetic element having a magnetic moment; and the storage layer is configured such that at least the magnetic element is dispersed in the antiferromagnetic material.
(7) The memory element according to any one of (2) to (6), wherein: the storage layer further includes a third ferromagnetic layer composed of a third ferromagnetic material, a magnetization direction of the third ferromagnetic material is configured to be reversible in conjunction with the sign of the anomalous Hall coefficient of the antiferromagnetic material, depending on the data written to the memory element; and the third ferromagnetic layer is configured to be coupled to the second ferromagnetic layer via the antiferromagnetic layer.
   According to the configuration as such, the magnetic coupling between the ferromagnetic material and the antiferromagnetic material in the storage layer can be further enhanced.
(8) The memory element according to any one of (2) to (7), wherein: a thickness of the antiferromagnetic layer is greater than a thickness of the second ferromagnetic layer.
   According to the configuration as such, the application of a magnetic field to the antiferromagnetic layer can be facilitated, while enhancing coupling to the spins in the second ferromagnetic layer.
(9) The memory element according to any one of (1) to (8), wherein: particles having a magnetic moment, included in the second ferromagnetic material, are configured to diffuse into the antiferromagnetic material.
   According to the configuration as such, it is possible to form a storage layer that is more compact and has a stronger magnetic moment.
(10) The memory element according to any one of (1) to (9), wherein: the first ferromagnetic material and the second ferromagnetic material each include at least a Co (cobalt) element as particles having a magnetic moment.
(11) The memory element according to (10), wherein: the first ferromagnetic material and the second ferromagnetic material are composed of Co or CoFeB.
(12) The memory element according to any one of (1) to (11), wherein: the antiferromagnetic material is composed of one or more materials selected from the group consisting of Mn₃Sn, Mn₃Pt, Mn₃Ge, Mn₃Ga, and Mn₃Ir.

Of course, the above are not the only possible implementations.

Finally, although various embodiments of the present disclosure have been described, these are presented merely as examples and are not intended to limit the scope of the invention. The novel embodiments may be implemented in various other forms, and various omissions, substitutions, and changes can be made without departing from the gist of the invention. Such embodiments and their modifications are included within the scope and gist of the invention, and also within the scope of the invention as defined in the claims and their equivalents.

### [Reference Signs List]

10: memory element
11: memory element
12: memory element
13: memory element
14: memory element
15: memory element
20: memory element
100: substrate
102: electrode
102: ferromagnetic layer
104: antiferromagnetic layer
105: first intermediate layer
106: ferromagnetic layer
107: second intermediate layer
108: barrier layer
108: ferromagnetic layer
109: third intermediate layer
110: ferromagnetic layer
112: upper layer
200: substrate
202: electrode
204: diffusion layer
206: barrier layer
208: ferromagnetic layer
210: upper layer
214: barrier layer
216: upper layer
1031: ferromagnetic layer
1032: fourth intermediate layer
F: pinned layer
M: storage layer

## Claims

1. A memory element comprising:
a pinned layer; and
a storage layer,
wherein the pinned layer is composed of a first ferromagnetic material having spontaneous magnetization, and a magnetization direction of the first ferromagnetic material is configured to remain fixed regardless of data written to the memory element; and
wherein the storage layer is configured to include an antiferromagnetic material and a second ferromagnetic material having spontaneous magnetization,
the antiferromagnetic material exhibits an anomalous Hall effect, and a sign of an anomalous Hall coefficient of the antiferromagnetic material is configured to be reversible depending on the data written to the memory element, and
a magnetization direction of the second ferromagnetic material is configured to be reversible in conjunction with the sign of the anomalous Hall coefficient of the antiferromagnetic material, depending on the data written to the memory element.

2. The memory element according to claim 1, wherein:
the storage layer includes an antiferromagnetic layer composed of the antiferromagnetic material and a second ferromagnetic layer composed of the second ferromagnetic material.

3. The memory element according to claim 2, further comprising:
a first insulating layer,
wherein the first insulating layer is disposed between the pinned layer and the storage layer, and is thereby configured to form a tunnel junction between the pinned layer and the storage layer, and
wherein the antiferromagnetic layer is configured to be connected to the first insulating layer via the second ferromagnetic layer.

4. The memory element according to claim 2 or claim 3, wherein:
the antiferromagnetic layer is configured to have an interface with the second ferromagnetic layer.

5. The memory element according to claim 4, wherein:
the second ferromagnetic material includes a magnetic element having a magnetic moment; and
the storage layer includes, in vicinity of the interface, a diffusion layer in which particles including the magnetic element of the second ferromagnetic material have diffused into the antiferromagnetic layer.

6. The memory element according to any one of claims 2 to 5, wherein:
the second ferromagnetic material includes a magnetic element having a magnetic moment; and
the storage layer is configured such that at least the magnetic element is dispersed in the antiferromagnetic material.

7. The memory element according to any one of claims 2 to 6, wherein:
the storage layer further includes a third ferromagnetic layer composed of a third ferromagnetic material,
a magnetization direction of the third ferromagnetic material is configured to be reversible in conjunction with the sign of the anomalous Hall coefficient of the antiferromagnetic material, depending on the data written to the memory element; and
the third ferromagnetic layer is configured to be coupled to the second ferromagnetic layer via the antiferromagnetic layer.

8. The memory element according to any one of claims 2 to 7, wherein:
a thickness of the antiferromagnetic layer is greater than a thickness of the second ferromagnetic layer.

9. The memory element according to any one of claims 1 to 8, wherein:
particles having a magnetic moment, included in the second ferromagnetic material, are configured to diffuse into the antiferromagnetic material.

10. The memory element according to any one of claims 1 to 9, wherein:
the first ferromagnetic material and the second ferromagnetic material each include at least a Co (cobalt) element as particles having a magnetic moment.

11. The memory element according to claim 10, wherein:
the first ferromagnetic material and the second ferromagnetic material are composed of Co or CoFeB.

12. The memory element according to any one of claims 1 to 11, wherein:
the antiferromagnetic material is composed of one or more materials selected from the group consisting of Mn₃Sn, Mn₃Pt, Mn₃Ge, Mn₃Ga, and Mn₃Ir.
